# EUROPÄISCHE PATENTANMELDUNG

(11) **EP 2 600 423 A1**
(43) Veröffentlichungstag der Anmeldung: **05.06.2013**
(21) Anmeldenummer: 12401237.8
(22) Anmeldetag: 30.11.2012
(51) Int. Cl.: H01L 31/042, H01L 31/052

(54) **Solarmodul-Dachmontagesystem**

(30) Priorität: 30.11.2011 DE 102011055903
(71) Anmelder: Beyersdorffer, Mathias, 29160 Crozon (FR)
(72) Erfinder: Beyersdorffer, Mathias, 29160 Crozon (FR)
(74) Vertreter: Heyerhoff Geiger & Partner Patentanwälte

(57) **Zusammenfassung**

Die Erfindung betrifft ein Solarmodul-Dachmontagesystem (8) mit Tragschienen (14) zum Tragen von Solarmodulen (10) und einem Kühlsystem (22) zum Kühlen der Solarmodule (10), das Kühlmittelleitungen (24) und Überträgerelemente (34, 44, 60) zum Übertragen von Wärme aus den Solarmodulen (10) auf die Kühlmittelleitungen (24) aufweist.

Eine hohe Variabilität bei der Auswahl von Solarmodulen (10) und Kühlungen sowie eine einfache, stabile und kostengünstige Montage der Solarmoduls (10) kann erreicht werden, wenn das Kühlsystem (22) unmittelbar an den Tragschienen (14) abgestützt ist.

## Beschreibung

Die Erfindung betrifft ein Solarmodul-Dachmontagesystem mit Tragschienen zum Tragen von Solarmodulen und einem Kühlsystem zum Kühlen der Solarmodule, das Kühlmittelleitungen und Überträgerelemente zum Übertragen von Wärme aus den Solarmodulen auf die Kühlmittelleitungen aufweist.

Photovoltaik-Dachmodule, im Folgenden vereinfacht PV-Module genannt, dienen zum Umwandeln von Sonneneinstrahlung in elektrische Energie. Bei einem solchen Umwandlungsprozess heizen sich die PV-Module auf, wodurch ihr Wirkungsgrad absinkt. Zur Lösung dieses Problems ist es bekannt, UV-Module zu kühlen, indem Kühlmittelleitungen an ihrer Rückseite entlang geführt werden die von Kühlmittel durchströmt werden. Zur Übertragung von möglichst viel Wärme in das Kühlmittel ist die Kühlmittelleitung möglichst eng am Wärme erzeugenden Halbleitermaterial des Solarmoduls angeordnet. Beispielsweise ist sie von unten an das Halbleitermaterial anlaminiert.

Bei der Montage werden die Solarmodule so aneinander angefügt, dass deren Kühlmitteleitungen miteinander verbunden werden, so dass ein Kühlleitungssystem entsteht.

Es ist eine Aufgabe der vorliegenden Erfindung, ein Solarmodul-Dachmontagesystem anzugeben, mit dem gekühlte PV-Module einfach auf einem Dach montiert werden können.

Diese Aufgabe wird durch ein Solarmodul-Dachmontagesystem der eingangs genannten Art gelöst, bei dem das Kühlsystem erfindungsgemäß unmittelbar an den Tragschienen abgestützt ist.

Die Erfindung geht hierbei von der Überlegung aus, dass die Verwendung eines Kühlsystems je nach Dachart, Montagestandort und Art der verwendeten PV-Module unterschiedlich effektiv ist. Von daher kann es sinnvoll sein, ein Solarsystem mit einer Vielzahl von PV-Modulen mit einem Kühlsystem aufzubauen und die gleichen PV-Module in einem anderen System, beispielsweise an einem anderen Standort, ohne ein Kühlsystem oder mit einem anderen Kühlsystem zu montieren.

Durch die enge thermische Verbindung von Kühlmittelleitungen und dem Halbleitermaterial des Solarmoduls ist das Kühlsystem bei gekühlten Solarmodulen üblicherweise fest in das Solarmodul integriert. Hierdurch wird die Auswahl von für einen Standort geeigneten Solarmodulen eingeschränkt.

Außerdem ist die Montage von in Solarmodulen integrierten Kühlsystemen bei verschiedenen Herstellern unterschiedlich, sodass das Montieren von solchen Solarmodulen mit integriertem Kühlsystem herstellerabhängig und eventuell komplex ist.

Gemäß der Erfindung ist das Kühlsystem unmittelbar an den Tragschienen abgestützt. Es kann hierdurch ein selbsttragendes Kühlsystem bilden, das unabhängig von den Solarmodulen auf dem Dach montiert werden kann. Das Kühlsystem und die Solarmodule können also jeweils einzeln an die Standortsituation und an Kundenwünsche angepasst werden.

Außerdem kann der weitere Vorteil erreicht werden, dass das Kühlsystem für eine Mehrzahl von unterschiedlichen Solarmodulen verwendbar ist, insbesondere für alle gängigen und insbesondere ungerahmten Solarmodule. Es kann somit eine einfache Montage der gekühlten Solarmodule und/oder eine hohe Variabilität bei der Kombination von Solarmodulen mit dem Kühlsystem erreicht werden.

Vorteilhafterweise sind das Kühlsystem und die Solarmodule einzeln und unabhängig voneinander in, an und/oder auf den Tragschienen abgestützt. Mit der Bezeichnung "an" den Tragschienen soll hierbei auch in den oder auf den Tragschienen umfasst sein. Es muss also kein Eingriff des Kühlsystems am Solarmodul erfolgen, sodass diese unabhängig voneinander gefertigt und insbesondere montiert werden können. Zweckmäßigerweise sind die Solarmodule am Dach vom Kühlsystem abhebbar beziehungsweise auf das Kühlsystem auflegbar.

Durch das erfindungsgemäße System kann eine Fläche von mehreren Photovoltaik-Modulen in einer besonders einfachen Weise zur solarthermischen Energiegewinnung genutzt werden. Hierbei wird das Temperaturniveau des Kühlsystems zweckmäßigerweise auf maximal 40°C eingestellt, damit die Solarmodule effektiv gekühlt werden.

Durch das erfindungsgemäße System kann die von den Solarmodulen abgegebene Wärme weiteren Betriebsprozessen zur Verfügung gestellt werden. So kann die Wärme zur Anhebung eines Heizungs-Rücklaufs verwendet werden. Ebenfalls möglich ist die Verwendung der Wärme in einer Niedertemperaturheizung, beispielsweise eine Bodenheizung und/oder einer Wandheizung. Ebenfalls vorteilhaft ist die Vorheizung einer Sole-Wasser-Wärmepumpe.

Das Solarmodul-Dachmontagesystem dient zweckmäßigerweise der Befestigung von auf einem Schrägdach angeordneten und als Dacheindeckung dienenden Solarmodulen. Die Solarmodule können bei einem solchen so genannten Indach-System Photovoltaikmodule, also PV-Module, und/oder Solarthermie-Module sein, die zum Umwandeln von Sonneneinstrahlung in Wärme vorgesehen sind.

Die Tragschienen können solche Schienen sein, die die Solarmodule unmittelbar tragen, wobei zwischen Solarmodulen und Tragschienen nur Dichtungen, Stoßabsorber oder dergleichen angeordnet sind. Zweckmäßigerweise verlaufen die Tragschienen in Ablaufrichtung eines Schrägdachs, also von einem First zur Traufe. Die Tragschienen können jedoch auch Querschienen sein, die beispielsweise waagerecht und/oder in Firstrichtung orientiert sind und die unterhalb der Tragschienen montiert sind.

In einer vorteilhaften Ausführungsform der Erfindung sind die Kühlmittelleitungen unmittelbar an den Tragschienen abgestützt. Hierdurch kann das Kühlsystem einfach und stabil befestigt beziehungsweise montiert werden.

Vorteilhafterweise sind die Kühlmittelleitungen durch Ausnehmungen in den Tragschienen geführt und in den Ausnehmungen relativ zu den Tragschienen zweidimensional positioniert gehalten. Hierdurch kann auf besonders einfache Weise eine sehr genaue Positionierung der Kühlmittelleitungen innerhalb der Tragschienen und damit innerhalb des gesamten Dachmontagesystems, erreicht werden.

Insbesondere wenn die Kühlmittelleitungen unmittelbar an den Tragschienen abgestützt sind, verlaufen die Tragschienen zweckmäßigerweise in Ablaufrichtung des Dachs, wobei die Kühlmittelleitungen vorteilhafterweise senkrecht zu den Tragschienen und in einer waagerechten Leitungsrichtung verlaufen. Hierdurch kann ein stabiles Kühlmittelleitungssystem einfach aufgebaut werden.

Zum Wärmeübertrag von Wärme aus den Solarmodulen in die Kühlmittelleitungen ist das Kühlsystem mit Überträgerelementen ausgestattet. Ein Überträgerelement kann ein Blechelement sein, das flächig unten an einem Solarmodul anliegt, Wärme aus dem Solarmodul sammelt und an eine Kühlmittelleitung weiterleitet. Es steht daher in möglichst direkter thermischer Verbindung mit dem Solarmodul und der Kühlmittelleitung.

Vorteilhafterweise liegen die Solarmodule unmittelbar auf den Überträgerelementen auf oder es ist lediglich eine thermische Verbindungsschicht zwischen dem entsprechenden Solarmodul und dem darunter liegenden Überträgerelement angeordnet. Die thermische Verbindungsschicht kann eine Wärmeleitpaste oder ein anderes Wärmeleitmittel sein, dessen Zweck die Wärmeleitung vom Solarmodul auf das darunter liegende Überträgerelement ist. Ebenfalls möglich ist eine dünne, Stoß absorbierende Schicht zum Schutz des Solarmoduls

Bei der Verwendung von großen Solarmodulen auf relativ flachen Dächern besteht das Problem, dass die Solarmodule bei einer hohen Schneelast unter Umständen stark durchbiegen und somit mechanisch belastet werden. Es ist daher sinnvoll, solche Solarmodule zwischen den Trägerschienen separat abzustützen. Eine solche Funktion kann durch das erfindungsgemäße Kühlsystem von den Überträgerelementen zumindest teilweise übernommen werden. Hierzu liegen die montierten Solarmodule vorteilhafterweise zwischen den Tragschienen auf dem Überträgerelement auf und werden durch diese gestützt. Es wird hierdurch ein Teil des Gewichts der Solarmodule auf die Überträgerelemente übertragen und von diesen - durch die unmittelbare Abstützung des Kühlsystems an den Tragschienen - an die Tragschienen weitergegeben.

Eine gute Lastweitergabe von Gewicht der Solarmodule beziehungsweise einer darauf liegenden Schneeschicht auf die Trägerschienen kann erreicht werden, wenn ein Überträgerelement zwischen den Tragschienen auf zumindest einer Kühlmittelleitung abgestützt ist. Auf diese Weise können die montierten Solarmodule zwischen den Tragschienen mittelbar über die Überträgerelemente auf den Kühlmittelleitungen abgestützt sein.

Jedes Überträgerelement unter einem Solarmodul muss erstens stabil befestigt werden, zweitens sollte es nach unten abgestützt werden, drittens sollte es exakt positioniert sein, um in exakter Position an dem Solarmodul anzuliegen und viertens sollte es in gutem Kontakt mit zumindest einer Kühlmittelleitung sein. Diese Bedingungen können zu einem hohen Montageaufwand führen.

In einer weiteren und besonders vorteilhaften Ausführungsform der Erfindung kann der Montageaufwand bei Einhaltung dieser Bedingungen gering gehalten werden, wenn die Überträgerelemente an den Kühlmittelleitungen verrastet sind. Zweckmäßigerweise ist jeweils ein Überträgerelement an einer Kühlmittelleitung verrastet. Da eine Kühlmittelleitung als stabiles Element eingesetzt werden kann, kann ein Überträgerelement stabil an der Kühlmittelleitung befestigt werden und außerdem nach unten an der Kühlmittelleitung abgestützt werden.

Ein guter Kontakt mit einer Kühlmittelleitung kann durch einen flächigen Kontakt erreicht werden. Hierzu liegen die beiden ineinander verrastenden Elemente von Überträgerelement und Kühlmittelleitung vorteilhafterweise flächig aneinander und zwar zweckmäßigerweise über zumindest 50% der Strecke, die das Überträgerelement die Kühlmittelleitung überdeckt. Verrastung kommt somit zweckmäßigerweise durch ein flächiges Anliegen aneinander zustande.

Eine exakte Positionierung kann erreicht werden, wenn die Kühlmittelleitung exakt zu zumindest einer Tragschiene positioniert ist. Dies kann erreicht werden, wenn die Kühlmittelleitung innerhalb einer Tragschiene befestigt ist, z.B. durch eine Ausnehmung - zweckmäßigerweise eine Bohrung - der Tragschiene geführt ist.

Durch die Verrastung kann die Montage stark vereinfacht werden. So kann beispielsweise zunächst die Kühlmittelleitung verlegt und befestigt werden. Anschließend kann ein Überträgerelement von oben auf die Kühlmittelleitung eingerastet und somit an dieser befestigt werden, ohne dass es eines Werkzeugs und/oder zusätzlicher Befestigungselemente bedarf.

Die Überträgerelemente können weiter vorteilhaft als Brandschutz verwendet werden. Im Defektfall kann es bei PV-Modulen dazu kommen, dass ein PV-Modul überhitzt und hierbei so heiß wird, dass sich eine Schicht auf dem PV-Modul entzünden kann, beispielsweise eine Beschichtung auf der Unterseite des PV-Moduls. Es ist daher vorteilhaft, wenn die PV-Module nach unten brandhemmend abgeschirmt sind. Eine solche Brand abschirmende Funktion kann den Überträgerelementen zukommen. Hierzu sind diese zweckmäßigerweise in Ablaufrichtung des Dachs übereinander angeordnet und bilden eine geschlossene Brandabschirmung unter einem Solarmodul. Auf diese Weise kann neben der Funktion der Wärmeabführung und einer eventuellen Unterstützung des Solarmoduls, beispielsweise bei Schneelast, eine dritte Funktion der Brandabschirmung von den Überträgerelementen übernommen werden.

In einer weiteren Ausführungsform der Erfindung wird vorgeschlagen, dass mehrere in Ablaufrichtung des Dachs übereinander angeordnete Überträgerelemente einen geschuppten Verbund bilden. Hierdurch kann der Vorteil erreicht werden, dass Wasser von oben nach unten über die Überträgerelemente abfließen kann, ohne dass es auf ein darunter liegendes Dachelement, beispielsweise eine Wärmedämmung, abtropft.

Weiter kann der Vorteil erreicht werden, dass die Überträgerelemente im geschuppten Verbund stabil mechanisch gelagert sind, sich also gegenseitig und aneinander abstützen. Der Verbund kann beispielsweise ein selbsttragender Verbund sein, sodass auf weitere Befestigungselemente ganz oder weitgehend verzichtet werden kann.

Außerdem wird vorgeschlagen, dass ein unter dem unteren Ende eines Solarmoduls angeordnetes Überträgerelement überschuppend auf einem Traufblech des Dachs aufliegt. Auf dem Überträgerelement angesammeltes Kondenswasser kann so aus dem Dach ausgeführt werden, ohne dass darunter liegende Dachelemente nass werden.

Eine übliche Kühlung von PV-Modulen besteht darin, diese so zu montieren, dass zwischen ihnen und einem darunter liegenden Dachaufbau ein Belüftungsraum zur Verfügung steht, der möglichst großflächig von Kühlluft durchstrichen werden kann. Hierdurch werden die PV-Module von unten durch den Kühlluftstrom gekühlt. Die im Kühlluftstrom aufgenommene Wärme der Solarmodule geht allerdings an die Umgebung verloren. Um diese Wärme jedenfalls teilweise nutzen zu können, wird vorgeschlagen, dass die Überträgerelemente einen Belüftungsstrom, der unter den Solarmodulen entgegen der Ablaufrichtung des Dachs strömt, zumindest teilweise stauen, sodass Wärme aus dem Belüftungsstrom in die Überträgerelemente überführt wird. Hierzu bilden die Überträgerelemente vorteilhafterweise Kammern, in denen nach oben aufgestiegene Luft unterhalb der Solarmodule gefangen ist. Diese Kammern werden zweckmäßigerweise von den Überträgerelementen in der Weise begrenzt, dass die in der Kühlluft befindliche Wärme aufgenommen und den Kühlmittelleitungen zugeführt werden kann.

Die Erfindung betrifft außerdem ein Photovoltaik-Dachsystem mit Photovoltaik-Modulen, Solarthermie-Modulen und einem Solarmodul-Dachmontagesystem, insbesondere wie oben beschrieben ist. Das Solarmodul-Dachmontagesystem umfasst zweckmäßigerweise ein Kühlsystem zum Kühlen der Solarmodule, das Kühlmittelleitungen und Überträgerelemente zum Übertragen von Wärme aus den Solarmodulen auf die Kühlmittelleitungen aufweist.

Es wird vorgeschlagen, dass die Kühlmittelleitungen so geführt sind, dass Kühlflüssigkeit in den Kühlmittelleitungen durch Wärme aus den Photovoltaik-Modulen vorgewärmt und durch Wärme aus den Solarthermie-Modulen nachgewärmt wird. Durch einen den PV-Modulen nachgeschalteten Solarthermiekollektor kann die Temperatur des Kühlmittels in den Kühlmittelleitungen erhöht werden, sodass auch Mitteltemperatur- oder Hochtemperaturanwendungen von der Wärme aus den Solarmodulen profitieren können. So kann die Abwärme von den Photovoltaik-Modulen beispielsweise zur Verbesserung der Effizienz von Hochtemperatur-Anwendungen eingesetzt wird, beispielsweise zur Aufheizung von Wasser oder zur Heizung eines Gebäudes.

Die Erfindung ist außerdem gerichtet auf ein Verfahren zur Montage eines Solarmodul-Systems auf dem Dach eines Gebäudes, bei dem Tragschienen zum Tragen von Solarmodulen an einen Dachunterbau angebracht werden und Solarmodule an den Tragschienen befestigt werden.

Es wird vorgeschlagen, dass erfindungsgemäß ein Kühlsystem - umfassend Kühlmittelleitungen und Überträgerelementen zum Übertragen von Wärme aus den Solarmodulen auf die Kühlmittelleitungen - an den Tragschienen verankert wird bevor die Solarmodule an den Tragschienen befestigt werden. Durch eine solche separate Montage von Kühlsystem und Solarmodulen kann die Montage erheblich vereinfacht werden und/oder es kann eine hohe Variabilität bei der Kombination von Kühlsystem und Solarmodul erreicht werden.

Vorteilhafterweise werden die Kühlmittelleitungen in die Ausnehmungen der auf dem Dach befestigten Tragschienen eingeschoben und zu einem Leitungssystem miteinander verbunden. Hierdurch können die Kühlmittelleitungen einfach montiert und sehr ortsgenau im Dach beziehungsweise innerhalb eines Verbunds aus Tragschienen positioniert werden.

Weiter wird vorgeschlagen, dass die Überträgerelemente an den Kühlmittelleitungen befestigt werden. Insbesondere werden die Überträgerelemente an den Kühlmittelleitungen eingerastet, wodurch eine schnelle und qualitativ zuverlässige Montage der Überträgerelemente erreicht werden kann.

Vorteilhafterweise werden die Solarmodule auf die Überträgerelemente aufgelegt, beispielsweise bei einem Auflegen der Solarmodule auf die Tragschienen. Hierdurch wird nicht nur eine Montage der Solarmodule einfach gehalten, sondern auch eine Zwischenabstützung der Solarmodule zwischen den Tagschienen erreicht.

Die bisher gegebene Beschreibung vorteilhafter Ausgestaltungen der Erfindung enthält zahlreiche Merkmale, die in den einzelnen Unteransprüchen teilweise zu mehreren zusammengefasst wiedergegeben sind. Diese Merkmale wird der Fachmann jedoch zweckmäßigerweise auch einzeln betrachten und zu sinnvollen weiteren Kombinationen zusammenfassen. Insbesondere sind diese Merkmale jeweils einzeln und in beliebiger geeigneter Kombination mit der erfindungsgemäßen Vorrichtung und dem erfindungsgemäßen Verfahren gemäß den unabhängigen Ansprüchen kombinierbar.

Die oben beschriebenen Eigenschaften, Merkmale und Vorteile der Erfindung, sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem unabhängigen Anspruch kombiniert werden.

Es zeigen:
- Fig. 1: eine Draufsicht auf ein Schrägdach mit einem teilweisen montierten Kühlsystem und einigen Solarmodulen,
- Fig. 2: einen Ausschnitt aus einer seitlichen Schnittdarstellung durch das Schrägdach mit einer Tragschiene, an der Kühlmittelleitungen abgestützt sind,
- Fig. 3: eine Seitenansicht auf ein Überträgerelement, das auf einer Kühlmittelleitung verrastet wird,
- Fig. 4: eine Draufsicht auf ein weiteres Schrägdach mit PV-Modulen und einer oberen Reihe von Solarthermie-Modulen,
- Fig. 5: eine schematische Schnittdarstellung durch ein Solarmodul aus der obersten Reihe der Solarmodule aus Fig. 4 und
- Fig. 6: zwei ineinander gesteckte Überträgerelemente an zwei Kühlmittelleitungen.

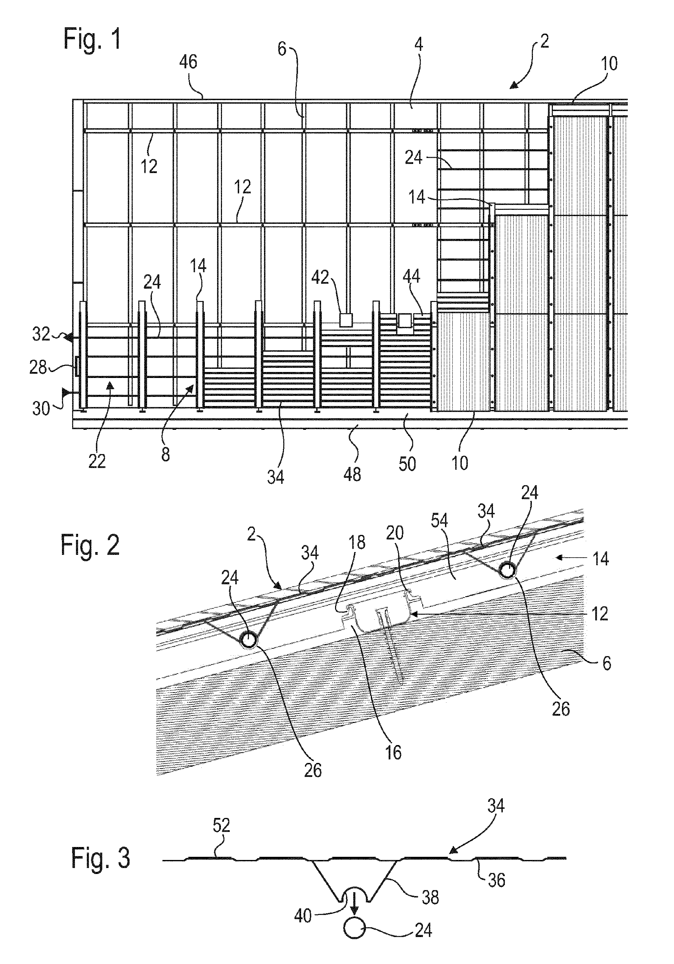

Fig. 1 zeigt eine Draufsicht auf ein Schrägdach 2 mit einem Dachunterbau 4, der Dachsparren 6 und zwischen diesen angeordneter Isolierung aufweist. Mit Hilfe eines Solarmodul-Dachmontagesystems 8 sind auf dem Schrägdach 2 eine Vielzahl von Solarmodulen 10 montiert, die als PV-Module ausgeführt sind. Das Solarmodul-Dachmontagesystem 8 umfasst hierzu Querschienen 12 und Tragschienen 14. Die Querschienen 12 sind auf die Dachsparren 6 aufgeschraubt, wie in Fig. 2 dargestellt ist.

Fig. 2 zeigt einen Ausschnitt einer seitlichen Schnittdarstellung durch das Schrägdach 2, mittig durch einen Dachsparren 6. Auf der gezeigten Querschiene 12 ist eine Tragschiene 14 befestigt, indem die Tragschiene 14 von oben auf der Querschiene 12 aufgerastet ist.

Auf dem Schrägdach 2 sind jeweils mehrere Tragschienen 14 der Länge nach hintereinander überschuppend zueinander angeordnet, analog wie die Solarmodule 10, die auf den Tragschienen 14 befestigt sind. Die Solarmodule 10 und das Solarmodul-Dachmontagesystem 8 bilden ein sogenanntes Indach-System, das eine Dacheindeckung mit beispielsweise Dachziegeln ersetzt.

Zur Montage der Solarmodule 10 mit Hilfe des Solarmodul-Dachmontagesystems 8 werden zunächst die Querschienen 12 in horizontaler Ausrichtung auf den Dachsparren 6 befestigt. Hierfür werden die Querschienen 12 mit jeweils einem Befestigungsmittel 16 pro Dachsparren 6 - im gezeigten Ausführungsbeispiel durch eine Schraube - am Dachsparren 6 befestigt, wobei das Befestigungsmittel symmetrisch in der Mitte des Profils der Querschiene 12 angeordnet ist. Anschließend werden die Tragschienen 14 von oben auf die Querschienen 12 aufgelegt und auf diese niedergedrückt, sodass die Tragschienen 10 mit den Querschienen 12 verrasten.

Die Tragschienen 14 sind wie die Querschienen 12 als Aluminium-Stranggussprofile hergestellt, wobei die Tragschienen 14 Ausnehmungen 16 aufweisen, in die die Querschienen 12 hereinreichen. In jede solche Ausnehmung 16 ragen beidseitig zwei Halteelemente 18 hinein, die an ihrer Unterseite eine Schräge aufweisen. Diese Schräge setzt bei einem Auflegen der Tragschiene 14 auf die Querschiene 12 auf den beiden gegenüberliegenden Oberkanten 20 der Querschiene 12 auf und drücken die beiden Oberkanten 20 bei einem Herunterdrücken der Tragschiene 14 auf die Querschiene 12 aufeinander zu. Bei einem weiteren Herunterdrücken springen die beiden entgegen gesetzten Ränder 20 oben über die Halteelemente 18 in ihre Ruheposition zurück und verrasten somit hinter den Halteelementen 18. Die Tragschiene 14 ist nun mit der darunterliegenden Querschiene 12 verrastet.

Zur Sicherung kann nun in die Querschiene 12 ein Innenblech eingelegt werden, dass die beiden Ränder 20 getrennt hält, sodass sie sich nicht in der Weise aufeinander zu bewegen können, dass die Verrastung gelöst wird.

Auf diese Weise wird jeweils eine Tragschiene 14 mit einer darunterliegenden Querschiene verrastet, wobei auf dem Schrägdach 2 von unten nach oben montiert wird, also die unteren Tragschienen 14 zuerst montiert werden, und die darüberliegenden dann überschuppend nachfolgend montiert werden.

Anschließend wird ein Kühlsystem 22 montiert. Dieses umfasst eine Vielzahl von Kühlmittelleitungen 24, die in diesem Ausführungsbeispiel größtenteils waagrecht auf dem Schrägdach 2 verlegt werden. Hierzu werden Rohre der Kühlmittelleitungen 24 durch Ausnehmungen 26 in die Tragschienen 14 geschoben, sodass sie von den Tragschienen 14 definiert zweidimensional positioniert gehalten werden. Die Ausnehmungen 26 sind in diesem Ausführungsbeispiel kreisrunde Bohrungen, durch die die Rohre hindurchgeschoben werden. Anschließend werden die Kühlmittelleitungen 24 durch Verbinderstücke 28 miteinander verbunden, sodass ein Leitungssystem mit einem Einlauf 30 und einem Auslauf 32 entsteht.

Fig. 1 zeigt die Kühlmittelleitungen 24 in einem teilmontierten Zustand, wobei einige Kühlmittelleitungen 24 noch frei liegen und auch zum Teil noch nicht zu einem Leitungssystem verbunden sind.

Bei dem in Fig. 1 gezeigten Ausführungsbeispiel verläuft ein Leitungssystem unter einer Reihe von Solarmodulen 10, wobei ein darüber liegendes Leitungssystem unter der darüber liegenden Reihe von Solarmodulen 10 verläuft. Es ist jedoch selbstverständlich auch möglich, ein Leitungssystem unter einer Mehrzahl von Reihen von Solarmodulen 10 verlaufen zu lassen.

Nach der Montage der Kühlmittelleitungen 24 in den Tragschienen 14 werden Überträgerelemente 34 des Kühlsystems 22 montiert. Ein solches Überträgerelement ist in Fig. 3 in einer Seitenansicht dargestellt.

Fig. 3 zeigt ein Überträgerelement 34, das ein profiliertes Blech 36 umfasst, das mit einem Halteelement 38 verbunden ist, das ebenfalls aus Blech ist und sich über die gesamte Länge des Halteelements 34 erstreckt. Die Länge des Halteelements 34 verläuft in Fig. 3 senkrecht zur Papierebene der Zeichnung.

Das Halteelement 38 weist eine teilzylinderförmige Öffnung 40 auf, die in ihrem Radius so bemessen ist, dass sie eine Kühlmittelleitung 24 gerade umgreift. Der Teilkreis dieser teilzylinderförmigen Öffnung 40 ist hierbei etwas mehr als 180°, sodass eine umgriffene Kühlmittelleitung 24 in der Öffnung 40 festgehalten bleibt. Durch die leichte Elastizität des Blechs des Halteelements 38 kann eine Kühlmittelleitung 34 in der Öffnung 40 verrastet werden. Hierbei berühren sich das Material der Kühlmittelleitung 24 und das zylinderförmige Blechsegment des Halteelements 38 innerhalb der teilzylinderförmigen Öffnung 40 flächig. Durch diese Ausformung der Überträgerelemente 34 kann ein Überträgerelement 34 auf eine Kühlmittelleitung 24 aufgelegt und auf diese herabgedrückt werden, sodass die Öffnung 40 mit der Kühlmittelleitung 24 verrastet. Das Überträgerelement 34 ist nun mit der Kühlmittelleitung 24 fest verbunden.

Durch die Halteelemente 38, die quer zur Ablaufrichtung des Schrägdachs 2 und somit auch quer zu einer Aufströmrichtung von Belüftungsluft liegen, die unter den Solarmodulen 10 und über dem Dachaufbau 4 von unten nach oben strömt, behindern die Halteelemente 38 einen solchen Belüftungsstrom. Zwischen ihnen sind eine Art Kammer 54 gebildet, in denen sich die Belüftung etwas staut. Hierdurch wird weniger Wärme durch Belüftung aus den Solarmodulen 10 nach außen abgetragen und die Überträgerelemente 34 werden stärker erwärmt, sodass mehr Wärme durch die Flüssigkeit der Kühlmittelleitungen 24 abgeführt werden kann.

In Fig. 1 sind mehrere solche Überträgerelemente 34 gezeigt, wobei sichtbar ist, dass jeweils vier Überträgerelemente 34 unter einem Solarmodul 10 auf vier Kühlmittelleitungen 24 befestigt sind. Fig. 1 zeigt die Überträgerelemente 34 in einem teilmontierten Zustand, wobei einige Kühlmittelleitungen 24 noch frei liegen und andere bereits mit den Überträgerelementen 34 verrastet sind.

Um eine Anschlussdose 42 herum können kleinere Überträgerelemente 44 beidseitig angeordnet sein, die entweder ebenfalls mit einer Kühlmittelleitung 24 verrastet sind oder auf eine andere Weise befestigt sind.

Die Überträgerelemente 34 können zwischen den Tragschienen 14 angeordnet sein und unabhängig von diesen montiert werden. Es ist ausreichend, wenn die Überträgerelemente 34 auf den Kühlmittelleitungen 24 befestigt werden, sodass eine Befestigung an den Tragschienen 14 oder den Querschienen 12 nicht notwendig ist. Um ein Verschieben seitlich zu vermeiden, können die Überträgerelemente 34 auf pass zwischen Tragschienen 14 montiert sein. Um ein Verkippen auf den Kühlmittelleitungen 24 zu vermeiden, sind die Überträgerelemente 34 zweckmäßigerweise überschuppend angeordnet, wie aus Fig. 2 zu erkennen ist, in der über der Querschiene 12 zwei Überträgerelemente 34 überschuppt positioniert sind. Das im Schrägdach 2 oberhalb gelegene Überträgerelement 34 überdeckt hierbei das im Schrägdach 2 darunter liegende Überträgerelement 34, sodass von oben nach unten in Ablaufrichtung, also von einem First 46 zu einer Traufe 48 fließendes Wasser vom oberen auf das untere Überträgerelement 34 abfließt. Das unterste Überträgerelement 34 liegt hierbei auf einem Traufblech 50 auf, sodass das herunter laufende Wasser auf das Traufblech 50 geführt wird.

Sind alle Überträgerelemente 34 unter einem noch zu montierenden Solarmodul 10 befestigt, so kann das Solarmodul 12 auf die Tragschienen 14 aufgelegt und dort befestigt werden. Hierbei liegt das Solarmodul 10 zweckmäßigerweise auch auf den darunter liegenden Überträgerelementen 34 auf, um eine gute Wärmeübertragung vom Solarmodul 10 auf die Überträgerelemente 34 zu erreichen. Um das Material der Solarmodule 10 zu schonen und/oder einen besseren Wärmeübertrag zu erreichen, kann zwischen einem Überträgerelement 34 und dem darauf liegenden Solarmodul 10 eine Verbindungsschicht 52 aufgebracht werden, beispielsweise in Form einer Wärmeleitpaste oder eines anderen geeigneten Materials.

Das Solarmodul 10 wird unabhängig von den Überträgerelementen 34 montiert und kann auch wieder von diesen abgenommen werden, ohne dass diese auch zu demontieren wären. Entsprechend ist das gesamte Kühlsystem 22 unabhängig von den Solarmodulen 10 montierbar und kein Element des Kühlsystems 22 greift in irgendeiner Weise in ein Solarmodul 10 ein. Auf diese Weise können beliebige rahmenlose Solarmodule 10 verschiedener Bauarten mit dem gleichen Kühlsystem 22 und dem gleichen Solarmodul-Dachmontagesystem 14 verbaut werden.

Dem Kühlsystem 22 und insbesondere den Überträgerelementen 34 können mehrere Funktionen einzeln oder gemeinsam zukommen. Zunächst können die Solarmodule 10 durch die Überträgerelemente 34 gekühlt werden, die ihre Wärme an die Kühlmittelleitung 24 und das darin geführte flüssige Kühlmittel abgeben. Hierdurch kann die Leistung der photovoltaischen Solarmodule 10 gesteigert werden.

Eine weitere Funktion ist die statische Unterstützung der Solarmodule 10. Da diese auf den Überträgerelementen 34 beziehungsweise der Zwischenschicht 52 aufliegen, werden die Solarmodule 10 zwischen den Tragschienen 14 von den Überträgerelementen 34 gestützt. Hierdurch sind die Solarmodule 10 in der Lage, eine große Schneelast zu tragen, ohne das die Gefahr einer Beschädigung der Solarmodule 10 besteht.

Das Gewicht der Überträgerelemente 34 und der darauf aufliegenden Solarmodule 10 wird auf die Kühlmittelleitungen 24 übertragen, die ihrerseits wieder in den Tragschienen 14 lagern und das Gewicht somit an die Tragschienen 14 weitergeben. Durch die Halterung durch die Lagerung der Überträgerelemente 34 auf den Kühlmittelleitungen und deren Lagerung in den Tragschienen 14 kann auf eine separate Befestigung der Überträgerelemente 34 an den Tragschienen 14 verzichtet werden, sodass die Montage der Überträgerelemente 34 sehr einfach ist.

Eine weitere Funktion ist der Brandschutz. Bei einer defekt bedingten Entflammung einer Schicht eines Solarmoduls 10, beispielsweise durch eine Überhitzung des Solarmoduls 10, wirken die übereinander geschuppt angeordneten Überträgerelemente 34 brandhemmend. Da diese aus einem Metallblech, vorzugsweise Aluminiumblech, hergestellt sind, kann ein direktes Durchschlagen von Flammen auf den darunter liegenden Dachunterbau 4 verhindert werden.

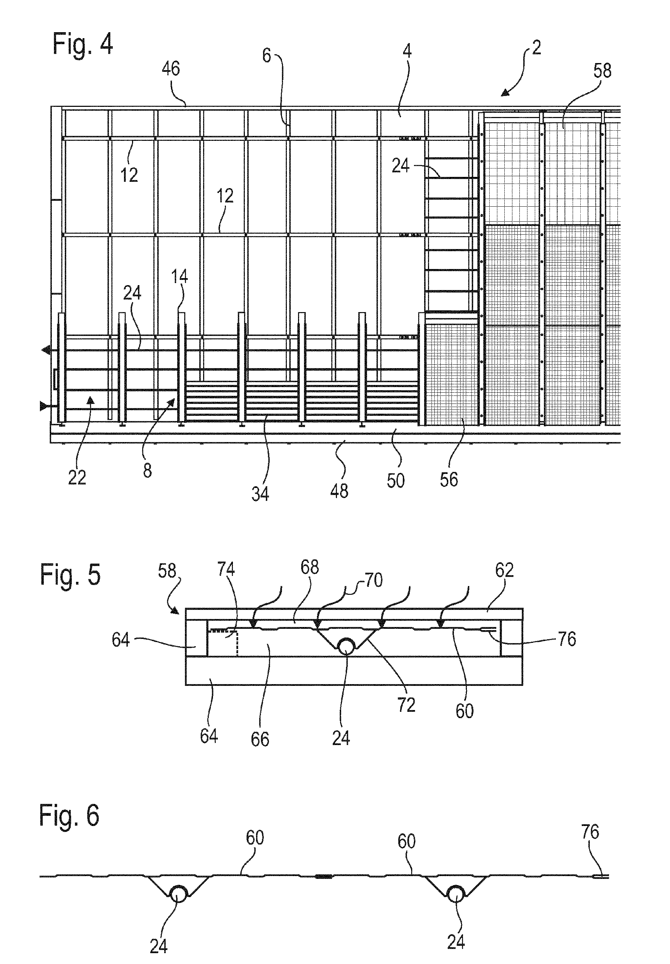

Ein weiteres Ausführungsbeispiel ist in Fig. 4 gezeigt. Die nachfolgende Beschreibung beschränkt sich im Wesentlichen auf die Unterschiede zum Ausführungsbeispiel in den Figuren 1 bis 3, auf das bezüglich gleich bleibender Merkmale und Funktionen verwiesen wird. Im Wesentlichen gleich bleibende Bauteile sind grundsätzlich mit den gleichen Bezugszeichen beziffert und nicht erwähnte Merkmale sind im folgenden Ausführungsbeispiel übernommen, ohne dass sie erneut beschrieben sind.

In den unteren Reihen der Solarmodule 10 auf dem Schrägdach 2 sind PV-Module 56 angeordnet, während in der obersten Reihe der Solarmodule 10 auf dem Schrägdach 2 Solarthermie-Module 58 angeordnet sind. Zur Montage der Solarthermie-Module 58 wird das gleiche Solarmodul-Dachmontagesystem 8 mit den gleichen Querschienen 12 und Tragschienen 14 verwendet wie bei den übrigen Solarmodulen 10, und die Solarthermie-Module 58 werden in gleicher Weise montiert, wie oben für die PV-Module 56 beschrieben ist. Auch das Kühlsystem 22 ist gleich konstruiert. Ein kleiner Unterschied liegt lediglich in den Abmessung der Überträgerelemente 60, die genau so aufgebaut sind, wie die Überträgerelemente 34, jedoch in ihrer Aufbauhöhe etwas flacher sind.

Fig. 5 zeigt einen Schnitt durch ein Solarmodul 10 aus der obersten Reihe der Solarmodule 10 aus Fig. 4. Anstelle des Halbleitermaterials der PV-Module 56 ist eine klare Glasplatte 62 vorhanden, das unter sich einen von Dämmung 64 umgebenen Luftraum 66 nach oben abschließt. In diesem Luftraum ist das Überträgerelement 60 angeordnet, liegt jedoch nicht an der Glasplatte 62 an, sondern lässt zwischen sich und der Glasplatte 62 eine Luftspalt 68 zur Wärmeisolierung. Sonneneinstrahlung 70 fällt durch die Glasplatte 62 auf das Überträgerelement 60 und heizt dieses auf. Dessen Wärme wird durch das in der Höhe etwas kleinere Halteelement 72 an die Kühlmittelleitung 24 und von dort an das Kühlmittel abgegeben.

In einer Kammer 54 eines Solarthermie-Modul 54 sind mehrere Überträgerelemente 60 nebeneinander angeordnet, analog zu den Überträgerelementen 34 unter einem PV-Modul 54. Falls jedoch eine Auflage des untersten Überträgerelemente 60 auf einer Stütze 72 nicht möglich ist, da diese nicht vorhanden sein muss, reicht eine Überschuppung zur Stabilitätsgebung gegebenenfalls nicht aus. Um dennoch eine ausreichende Stabilität der Positionierung der Überträgerelemente 60 zu erreichen, können diese mit einem Eingriff 74 ausgestattet sein, in den ein benachbartes Überträgerelement 60 eingreift. Ein solches Ineinandergreifen von zwei benachbarten Überträgerelementen 60 ist in Fig. 6 gezeigt.

Bei einer wie in Fig. 4 gezeigten Kombination von PV-Modulen 56 und Solarthermie-Modulen 58 kann die in den PV-Modulen 56 erzeugte Wärme besonders gut zur Vorheizung eines Hochtemperatur-Kreislaufs verwendet werden. Hierzu werden Kühlmittelleitungen 24 aus den PV-Modulen 56 mit Kühlmittelleitungen 24 der Solarthermie-Module 58 verbunden, so dass von den PV-Modulen 56 erwärmtes Kühlmittel zu den Solarthermie-Modulen 58 strömt. Beispielsweise werden die Kühlmittelleitungen 24 zu einem einzigen Kreislauf verbunden, der die PV-Module 56 und die Solarthermie-Module 58 durchströmt.

### Bezugszeichenliste

- 2: Schrägdach
- 4: Dachunterbau
- 6: Dachsparren
- 8: Solarmodul-Dachmontagesystem
- 10: Solarmodul
- 12: Querschiene
- 14: Tragschiene
- 16: Ausnehmung
- 18: Halteelement
- 20: Rand
- 22: Kühlsystem
- 24: Kühlmittelleitung
- 26: Ausnehmung
- 28: Verbindungsstück
- 30: Einlauf
- 32: Auslauf
- 34: Überträgerelement
- 36: Blech
- 38: Halteelement
- 40: Öffnung
- 42: Anschlussdose
- 44: Überträgerelement
- 46: First
- 48: Traufe
- 50: Traufblech
- 52: Verbindungsschicht
- 54: Kammer
- 56: PV-Modul
- 58: Solarthermie-Modul
- 60: Überträgerelement
- 62: Glasplatte
- 64: Dämmung
- 66: Luftraum
- 68: Luftspalt
- 70: Sonneneinstrahlung
- 72: Halteelement
- 74: Stütze
- 76: Eingriff

## Patentansprüche

1. Solarmodul-Dachmontagesystem (8) mit Tragschienen (14) zum Tragen von Solarmodulen (10) und einem Kühlsystem (22) zum Kühlen der Solarmodule (10), das Kühlmittelleitungen (24) und Überträgerelemente (34, 44, 60) zum Übertragen von Wärme aus den Solarmodulen (10) auf die Kühlmittelleitungen (24) aufweist,
**dadurch gekennzeichnet, dass** das Kühlsystem (22) unmittelbar an den Tragschienen (14) abgestützt ist.

2. Solarmodul-Dachmontagesystem (8) nach Anspruch 1,
**dadurch gekennzeichnet, dass** die Kühlmittelleitungen (24) unmittelbar an den Tragschienen (14) abgestützt sind.

3. Solarmodul-Dachmontagesystem (8) nach Anspruch 1 oder 2,
**dadurch gekennzeichnet, dass** die Kühlmittelleitungen (24) durch Ausnehmungen (26) in den Tragschienen (14) geführt sind und in den Ausnehmungen (26) relativ zu den Tragschienen (14) zweidimensional positioniert gehalten sind.

4. Solarmodul-Dachmontagesystem (8) nach einem der vorhergehenden Ansprüche,
**dadurch gekennzeichnet, dass** die Tragschienen (14) in Ablaufrichtung des Dachs (2) ausgerichtet sind.

5. Solarmodul-Dachmontagesystem (8) nach einem der vorhergehenden Ansprüche,
**dadurch gekennzeichnet, dass** die montierten Solarmodule (10) zwischen den Tragschienen (14) auf Überträgerelementen (34, 44) aufliegen und durch diese gestützt werden.

6. Solarmodul-Dachmontagesystem (8) nach einem der vorhergehenden Ansprüche,
**dadurch gekennzeichnet, dass** die Überträgerelemente (34, 44, 60) zwischen den Tragschienen (14) auf Kühlmittelleitungen (24) abgestützt sind.

7. Solarmodul-Dachmontagesystem (8) nach einem der vorhergehenden Ansprüche,
**dadurch gekennzeichnet, dass** die Überträgerelemente (34, 44, 60) an den Kühlmittelleitungen (24) verrastet sind.

8. Solarmodul-Dachmontagesystem (8) nach einem der vorhergehenden Ansprüche,
**dadurch gekennzeichnet, dass** mehrere in Ablaufrichtung des Dachs (2) übereinander angeordnete Überträgerelemente (34, 44, 60) einen geschuppten Verbund bilden.

9. Solarmodul-Dachmontagesystem (8) nach einem der vorhergehenden Ansprüche,
**dadurch gekennzeichnet, dass** mehrere in Ablaufrichtung des Dachs (2) übereinander angeordnete Überträgerelemente (34, 44, 60) eine geschlossene Brandabschirmung unter einem Solarmodul (10) bilden.

10. Solarmodul-Dachmontagesystem (8) nach einem der vorhergehenden Ansprüche,
**dadurch gekennzeichnet, dass** die Überträgerelemente (34, 44) einen Belüftungsstrom, der unter den Solarmodule (10) entgegen der Ablaufrichtung des Dachs (2) strömt, stauen, so dass Wärme aus dem Belüftungsstrom in die Überträgerelemente (34, 44) überführt wird.

11. Solarmodul-Dachsystem mit Photovoltaik-Modulen (56), Solarthermie-Modulen (58) und einem Solarmodul-Dachmontagesystem (8) nach einem der vorhergehenden Ansprüche,
**dadurch gekennzeichnet, dass** die Kühlmittelleitungen (24) so geführt sind, dass Kühlflüssigkeit in den Kühlmittelleitungen durch Wärme aus den Photovoltaik-Modulen (56) vorgewärmt und durch Wärme aus den Solarthermie-Modulen (58) nachgewärmt wird.

12. Verfahren zur Montage eines Solarmodul-Dachsystems auf dem Dach (2) eines Gebäudes, bei dem Tragschienen (14) zum Tragen von Solarmodulen (10) an einem Dachunterbau (4) angebracht werden und Solarmodule (10) an den Tragschienen (14) befestigt werden,
**dadurch gekennzeichnet, dass** ein Kühlsystem (22) - umfassend Kühlmittelleitungen (24) und Überträgerelementen (34, 44, 60) zum Übertragen von Wärme aus den Solarmodulen (10) auf die Kühlmittelleitungen (24) - an den Tragschienen (14) verankert wird bevor die Solarmodule (10) an den Tragschienen (14) befestigt werden.

13. Verfahren nach Anspruch 12,
**dadurch gekennzeichnet, dass** die Kühlmittelleitungen (24) in Ausnehmungen der auf dem Dach (2) befestigten Tragschienen (14) eingeschoben und zu einem Leitungssystem miteinander verbunden werden.

14. Verfahren nach Anspruch 12 oder 13,
**dadurch gekennzeichnet, dass** die Überträgerelemente (34, 44, 60) an den Kühlmittelleitungen (24) eingerastet werden.

15. Verfahren nach einem der Ansprüche 12 bis 14,
**dadurch gekennzeichnet, dass** die Solarmodule (10) auf die Überträgerelemente (34, 44) aufgelegt werden.
